# EUROPEAN PATENT APPLICATION

(11) **EP 1 772 876 A2**
(43) Date of publication of application: **11.04.2007**
(21) Application number: 06018840.6
(22) Date of filing: 08.09.2006
(51) Int. Cl.: H01C 17/242

(54) **Trimmable resistor and method of manufacture thereof**

(30) Priority: 07.10.2005 US 724417 P; 29.08.2006 US 511544
(71) Applicant: E.I. du Pont de Nemours and Company, Wilmington, DE 19898 (US)
(72) Inventor: Akimoto, Hideki, Tochigi-ken 321-0135 (JP)
(74) Representative: Hughes, Andrea Michelle

(57) **Abstract**

Described herein is a resistor (11) to which a trimming process is applied (hereinafter, also called a trimming resistor), a method for manufacturing a trimming resistor (11) and a circuit substrate (30a) using the trimming resistor (11).

## Description

### FIELD OF THE, INVENTION

Described herein is a resistor to which a trimming process is applied (hereinafter, also called a trimming resistor). More specifically, the present invention pertains to a trimming resistor, a method for manufacturing a trimming resistor and a circuit substrate using the trimming resistor.

### TECHNICAL BACKGROUND

In a trimming resistor, a trimming process (resistance value adjustment) is applied to a resistor formed on a circuit substrate and a resistor element containing a pair of electrodes connected to both ends of the resistor. Usually, the trimming resistor is assembled into a circuit substrate to appropriately operate the circuit substrate. The trimming resistor is formed on the circuit substrate by adjusting the resistance value of the non-trimmed resistor after the resistor making process. The trimming resistor may be formed, for example, by laser trimming. The laser trimming increases the resistance value by removing part of the resistor using the laser, thereby adjusting the resistance to a desired resistance value.

However, when the laser trimming is carried out, it is difficult to remove only the resistor portion on the circuit substrate and part of the substrate is likely to be removed along with the resistor. For this reason, the substrate is likely to be damaged by the laser, and there is a possibility that the reliability of a device on the circuit substrate will be declined. In particular, if a polymer-type organic laminate is used as the circuit substrate, the substrate do not have high heat resistance, the substrate is highly likely to be damaged by the irradiating heat of the laser. Also, when organic laminate is used, the coefficient of thermal expansion (CTE) of the substrate is much larger than CTE of the resistor. For this reason, once cracks are generated in the resistor by the laser, there is a possibility that the degree of cracking will be increased by the temperature change thereafter. In this case, the resistance value of the resistor is rapidly increased, and the intended resistance value is not likely to be obtainable. This may cause a disconnection of a circuit.

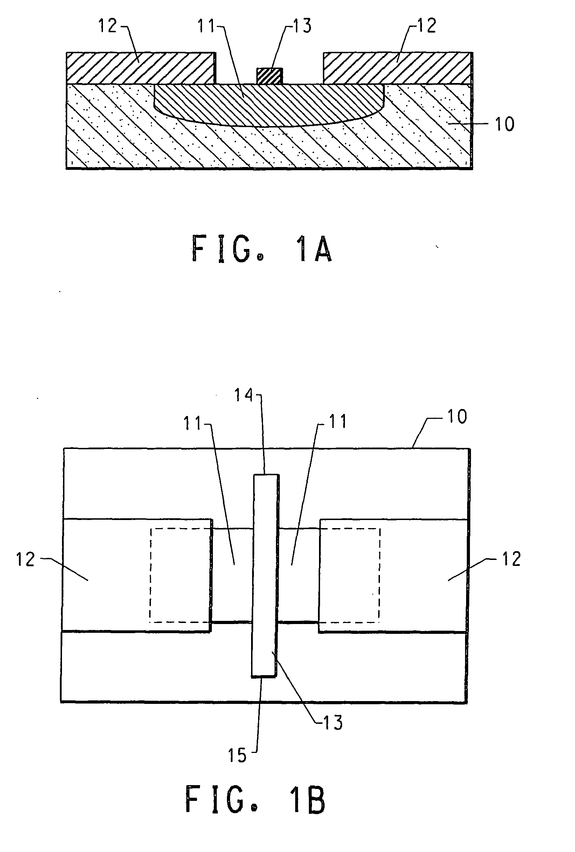

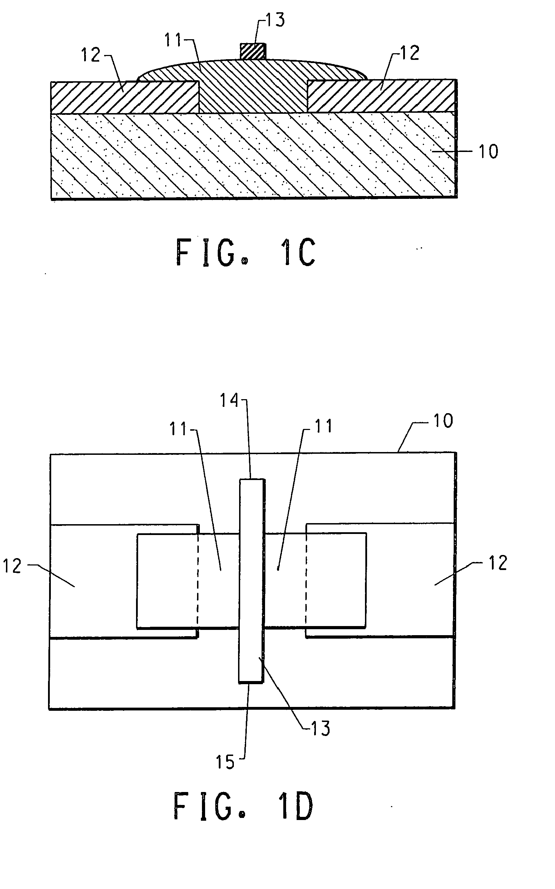

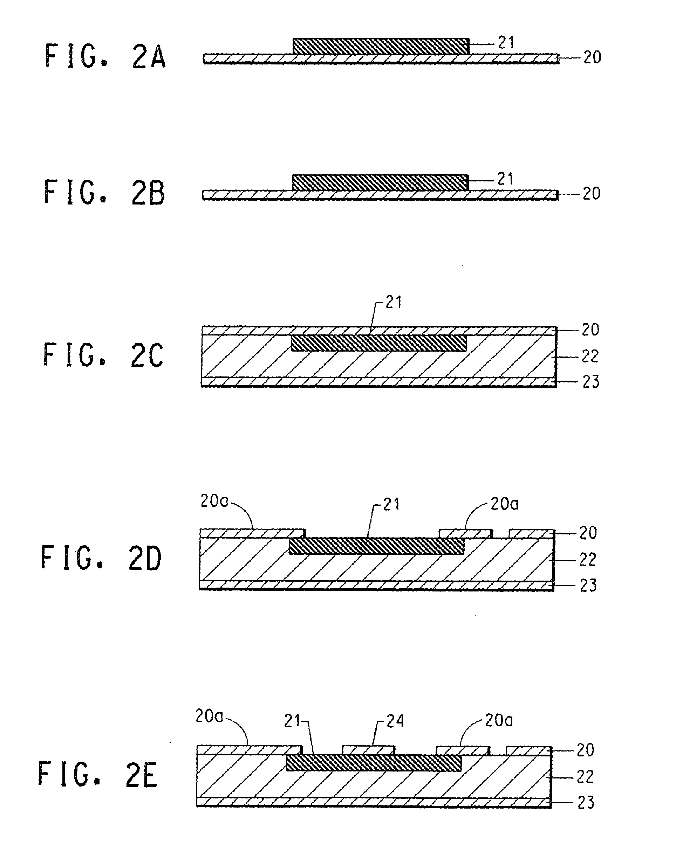

In view of this situation, various methods for forming the trimming resistor that do not damage the substrate and do not use a laser have been developed. In JP H 05[1993]-13206, for example, a method is described that spreads a trimming composition on a resistor. Figure 1 of this publication shows a method that forms several electroconductive pads on a substrate and adjusts the resistance value by connecting the electroconductive pads by a trimming composition, such as electroconductive paste. Figure 2 of JP H05[1993]-13206 shows a method that forms a resistor on a substrate and adjusts the resistance value by spreading a trimming composition such as an electroconductive paste with a resistance value lower than that of the resistor on it. A dispenser is shown as a means for spreading the electroconductive paste. In the method described in Figure 1 a special pad pattern for trimming is required. For this reason, the area of a semiconductor circuit is increased, and the manufacturing processes are likely to be complicated. In the method described in Figure 2, one end of the spreading part is positioned on the resistor when spreading using an electroconductive paste. In Figure 2, the spreading position of the electroconductive paste is shifted, and the resistance is likely to deviate from the expected resistance value.

A trimming resistor in which an expected resistance value can be obtained with high precision would be a desirable improvement.

### SUMMARY

An aspect of the invention relates to a trimming resistor which contains a resistor body disposed on a circuit substrate; and a trimming part disposed on the resistor body, the trimming part protruding from the both ends of the resistor body and across the direction of the electric current in the resistor body. Another aspect of the present invention relates to a method for production of a trimming resistor, which includes steps of: preparing a resistor body disposed on a circuit substrate; and applying a trimming composition so that a trimming part, which is formed by curing the trimming composition, can protrude from both ends of the resistor body corresponding to the direction of the flow of electric current, the conductivity of the trimming part being different from the conductivity of the resistor, and across the direction of the electric current in the resistor body. In the above method the trimming composition may be spread by using a dispenser, an ink jet device or by hand application. In one embodiment the step of applying and spreading the trimming composition is by use of an ink jet device.

A further aspect of the present invention relates to a circuit substrate equipped with the above-mentioned trimming resistor.

### BRIEF DESCRIPTION OF THE DRAWINGS

Figure 1 shows a circuit, in which the trimming resistor of the present invention is formed on a substrate, and (a) is a side view showing a side down type circuit, (b) is its plan view, (c) is a side view showing a side up type circuit, and (d) is its plan view.
Figure 2 sequentially explains the manufacturing processes of the side down type circuit shown in Figures 1(a) and (b).
Figure 3 sequentially explains the manufacturing processes of the side up type circuit shown in Figures 1(c) and (d).
Figure 4 sequentially explains the manufacturing processes of a circuit substrate using the side down type circuit shown in Figure 2(e).
Figure 5 sequentially explains the manufacturing processes of a circuit substrate using the side up type circuit shown in Figure 3(c).

### DETAILED DESCRIPTION

The present invention pertains to a trimming resistor in which a trimming composition with an electric conductivity different from that of a resistor is spread in a prescribed pattern on the surface of the resistor. In particular, the trimming resistor of the present invention is a trimming resistor in which the manufacturing processes can be simplified and an expected resistance value can be obtained with high precision. In the trimming resistor of the present invention, the probability is raised that an expected resistance can be obtained with high precision by one-time trimming through a specific spreading of the trimming composition. However, the present invention does not exclude a readjustment of the resistance value, and, if necessary, a readjustment or trimming may also be applied two or more times.

All electrical conductive ink can be applied to the trimming composition. The electrical conductivity of the trimming composition may be the same as that of the resistor, on which a trimming composition is applied. The electrical conductivity of the trimming composition may be higher or lower than that of the resistor. The electrical conductivity of the trimming composition has a relationship to the amount of resistance value being changed by trimming. If the resistance value of the trimming composition is low, the amount of resistance value being changed by trimming is increased. For a higher-precision trimming, a trimming composition with a high resistance value can also be used to reduce the amount being changed. High efficiency trimming is made possible by selecting a trimming composition suitable for the necessary amount of resistance value being changed. In case that the electrical conductivity of the trimming composition is the same as that of the resistor, the same trimming composition can be used for both the resistor and the trimming resistor. This can reduce a production cost.

The trimming resistor of the present invention consists of a resistor formed on a circuit substrate, and a trimming part that is formed on the above-mentioned resistor, protruding to the outside of both sides of the above-mentioned resistor, across the direction to the current flow direction in the above-mentioned resistor, and has an electric conductivity different from that of the above-mentioned resistor.

In the figures, 10 is a prepreg, 11 is a resistor, 12 is an electrode, and 13 is a trimming part. In two kinds of circuit substrates shown in Figure 1, the prepreg 10 is a substrate used as the base for forming circuit elements, such as trimming resistor. The resistor 11 is a side down type (Figure 1(a)) or a side up type (Figure 1(c)) element. The electrodes 12 are a pair of electrodes that are positioned on the prepreg 10 and partially connected to the resistor 11. The trimming part 13 is an element spread on the resistor 11 to adjust the resistance value. In the present invention, the trimming part 13 protrudes to the outside of both sides of the resistor 11 corresponding to the electric current flow direction in the resistor 11. Here, the "current flow direction" means a direction for connecting the electrodes 12. The [phrase] "both sides of the resistor across the direction of current flow" means the boundary of the electrode connecting direction of the external boundary constituting the resistor. Both ends 14 and 15 of the trimming part 13 extend to the outside of the resistor 11 as shown in Figures 1(b) and 1(d).

In the trimming resistor of the present invention, even if the spreading position of the trimming part 13 onto the resistor 11 is moved to along with the electric current direction, resistor value doesn't shift from an intended resistance value. For example, even if the forming position of the trimming part 13 of Figure 1 is shifted to one side of the electrodes 12, there is no change in the area of the trimming part 13 on the resistor 11. Also, even if the forming position of the trimming part 13 of Figure 1 is shifted in the direction perpendicular to the electric current flow direction, since the ends 14 and 15 of the trimming part 13 protrude, there is also no change in the area of the trimming part 13 on the resistor 11. Thus, in the present invention, even if the spreading of the trimming composition is shifted, effective trimming is realized. The degree of freedom for the spreading of the trimming composition is high and effective workability can be realized, even without using a high-precision spreading control. The shape of the trimming part 13 is not particularly limited. Trimming 13 with an oblong shape shown in Figure 1 is preferable in terms of design of the circuit substrate, however if the oblong trimming is difficult, a trimming resistor with a parallelogram shape may be used, or an oblong trimming resistor with a rounded corner shape may be used.

The substrate can be a ceramic type substrate using alumina or aluminum nitride or an organic laminate using a plastic material can be used. However, the substrate is not limited to these materials, and any material that can support the resistor and the electrodes can be utilized in forming the trimming resistor of the present invention.

Since an organic laminate may be damaged by heat, it is difficult to use it in laser trimming at a relatively high temperature. However, if the trimming composition is spread on the resistor, an organic laminate can be used.

If an organic laminate is used as the substrate, the CTE of the substrate is much larger than the CTE of the resistor. For this reason, once cracks are occurred on the substrate, the resistance value is raised by the temperature change thereafter, and a disconnection may result. If an organic laminate is used as the substrate, since the CTE is large, the dimension of substrate is not absolute, the spreading position of the trimming composition is likely to be shifted. In consideration of these characteristics of the organic laminate, the present invention is useful especially for the case where the substrate is the organic laminate.

The resistor is formed to control the resistance value in the circuit. The composition of the resistor is not particularly limited. For example, a baked resistor or a polymeric resistor may be used. A resistor containing a phenol group resin and a carbon powder may be used for the polymeric resistor.

The resistor can be manufactured using a resistor composition on the market. A product on the market of the baked type, for example, is Interra^{™} made by the DuPont Company. A product on the market of the polymeric type is the TU series of Asahi Chemical Institute K.K.

The electrodes are formed on the substrate and connected to both ends of the resistor. Copper foil or other materials can be used for the electrode.

As mentioned above, the trimming resistor of the present invention is obtained by spreading a trimming composition on a resistor without forming a pad pattern on a substrate. In the trimming resistor of the present invention, even if the spreading position of the trimming composition is moved to a greater or lesser degree, the effective area of the trimming part is not changed. Since the trimming composition is spread so that it may protrude to the outside of both sides of the resistor, even if the spreading of the trimming composition is shifted, the area formed on the resistor is not changed. This prevents the resistance value from being shifted from a desired value by the shift of the spreading position of the trimming composition.

The trimming part is formed by spreading and curing a trimming composition. The trimming part may be selected in consideration of desired electric conductivity, adhesion to the resistor or other desired characteristics. The trimming part is formed on the resistor to adjust the resistance value in the circuit, after assembling the circuit.

For example, if the trimming composition is spread to lower the resistance value of the resistor, electroconductive particles are included in the trimming composition to provide an electric conductivity higher than that of the resistor. Specific electroconductive particles, for example, include, but are not limited to, metals such as silver, copper, palladium, tungsten, nickel, tantalum, bismuth, lead, indium, tin, zinc, titanium, aluminum, gold, platinum, alloys of these metals of certain oxides of these metals or alloys may be used. An example of an oxide of a metal is ITO [indiumtin oxide].

In addition to the above metals the electroconductive particles may be constructed of other materials. A material with a shaped mixture of these metals and a polymers may also be used. Also, polymer particulates, whose surfaces are coated with the above-mentioned metals by plating with electroconductors, may also be used.

The electroconductive particles may eventually develop an electric conductivity. It is not necessary to already have an electric conductivity when the trimming composition is composed of particles. For this reason, the trimming composition can be adjusted by using the particles of a nonconductive organic metal compound containing a metal or an organic compound and spread on a prescribed position. In this case, the metal compound containing a nonconductor is decomposed by applying heat treatment, chemical treatment, or other methods to the spread adjusted composition, and the trimming part composed of a metal or a metal compound can be formed at a prescribed position.

The size of the electroconductive particles is not particularly limited. In the method for spreading the trimming composition, it is preferable for the particle diameter to be small when the composition is spread by an ink-jet device. Specifically, particles with a primary particle diameter of 100 nm or less easily maintain a stable colloidal state. Also, if the secondary particle diameter is 200 nm or less, the ink flowability and the ink coating of the ink-jet device are improved.

The mass of the electroconductive particles of the trimming composition in one embodiment is 5 mass% or more and less than 95 mass% of the total mount of trimming composition and in another embodiment 10 mass% or more and less than 80 mass% of the total amount of trimming composition. If the ink-jet device is used, it is preferable to determine the content of the electroconductive particles and other components while carefully watching the viscosity. The desirable viscosity depends on the ink-jet device. Heads used in the ink-jet device are a low-viscosity type, intermediate-viscosity type, high-viscosity type, etc., and the viscosity may be selected in accordance with the head being used. For example, if the low-viscosity type is used, the viscosity at 25°C is controlled to 0.530-15 cP, in the case where the intermediate-viscosity type is used, the viscosity is controlled to 5-50 cP, and in the case where the high-viscosity type is used, the viscosity is controlled to 10-10,000 cP. When a composition is spread by an ink-jet device, it is important to improve the dispersion stability and the densification, etc., of the film being formed. In addition to the above-mentioned components, for example, if a polyhydric alcohol or polyether compound is included, the dispersion stability and the densification of the thin film containing a metal are improved.

The polyhydric alcohol may be selected from the group including but not limited to ethylene glycol, diethylene glycol, 1,2-propanediol, 1,3-propanediol, 1,2-butanediol, 1,3-butanediol, 1,4-butanediol, 2-butene-1,4-diol, 2,3-butanediol, pentanediol, hexanediol, octanediol, glycerol , 1,1,1-trishydroxyethylethane, 2-ethyl-2-hydroxymethyl-1,3-propanediol, 1,2,6-hexanetriol, 1,2,3-hexanetriol, and 1,2,4-butanetriol. Also, sugar alcohols, such as glycerol, threitol, erythritol, pentaerythritol, pentitol, and hexitol can be used.

The amount of polyhydric alcohol being added is preferably 0.1 mass% - 95 mass%, more preferably 1 mass% - 90 mass% of the total amount of trimming composition, in consideration of the dispersibility of the electroconductive particles. These polyhydric alcohols can be used alone or in mixtures of several kinds.

Examples of the polyether compound include a polyether homopolymer such as polyethylene glycol, polypropylene glycol, and polybutylene glycol; a binary copolymer such as ethylene glycol/propylene glycol and ethylene glycol/butylene glycol; and a ternary straight-chain copolymer such as ethylene glycol/propylene glycol/ethylene glycol, propylene glycol/ethylene glycol/propylene glycol and ethylene glycol/butylene glycol/ethylene glycol.

The amount of polyether compound being added is preferably 0.1 mass% - 70 mass% of the total amount of compound in consideration of ink viscosity, film formability, etc. Also, the amount is more preferably 1 mass% - 50 mass%. These polyether compounds can be used alone or in combinations of several polyhydric alcohols.

Components of trimming compositions presented in JP 2005-019248, 2004-277627, and 2002-324966 (patent references 2-4) can be appropriately used. However, the use of trimming composition components other than the above-mentioned components is not excluded.

A method for manufacturing the trimming resistor consists of a step that prepares a resistor formed on a circuit substrate, and a step that spreads a trimming composition with an electrical conductivity different from that of the above-mentioned resistor, so that it may protrude to the outside of both sides of the above-mentioned resistor, corresponding to the current flow direction in the above-mentioned resistor.

Figures 2(a)-(e) sequentially explain the manufacturing processes of a side down type circuit substrate. In Figures 2(a) - (e), 20 is an electrode, 21 is a resistor, 22 is a prepreg, 23 is an electrode, and 24 is a trimming part.

When the side-down type circuit substrate is formed, first, as shown in Figure 2(a), the shaped-paste resistor 21 is printed and dried on the Cu foil 20. As the printing method, for example, screen printing is used. As shown in Figure 2(b), the resistor 21 is printed on the Cu foil 20 is baked with the Cu foil 20. Furthermore, as shown in Figure 2(c), the Cufoil 23 and the Cu foil 20 with the resistor 21 are laminated via the prepreg 22 by a hot press machine. At that time, the resistor 21 is embedded into the prepreg 22. Also, to build the resistor into both surfaces of the prepreg 22, the Cu foil in which the resistor is baked are laminated on both surfaces of the prepreg 22. In this manner, a layer composed of Cu foil 23, prepreg 22, resistor 21, and Cu foil 20 is formed. Next, as shown in Figure 2(d), the Cu foil 20 on the upper surface of the prepreg 22 is etched in a desired shape, electrical contact part 20a is worked as electrode, so that a circuit is formed.

To control the resistance value of the resistor formed on the circuit substrate, a trimming resistor is formed. In the method for manufacturing the trimming resistor of the present invention, as shown in Figure 2(e), the trimming composition 24 is spread on the resistor 21. At that time, as shown in Figure 1(b), the trimming composition is spread so that both ends 14 and 15 of the trimming part 13 (24) may protrude to the outside of both sides of the resistor. In this manner, the trimming resistor consisting of electrode 20a, resistor 21, and trimming part 24 is formed on the prepreg (substrate) 22.

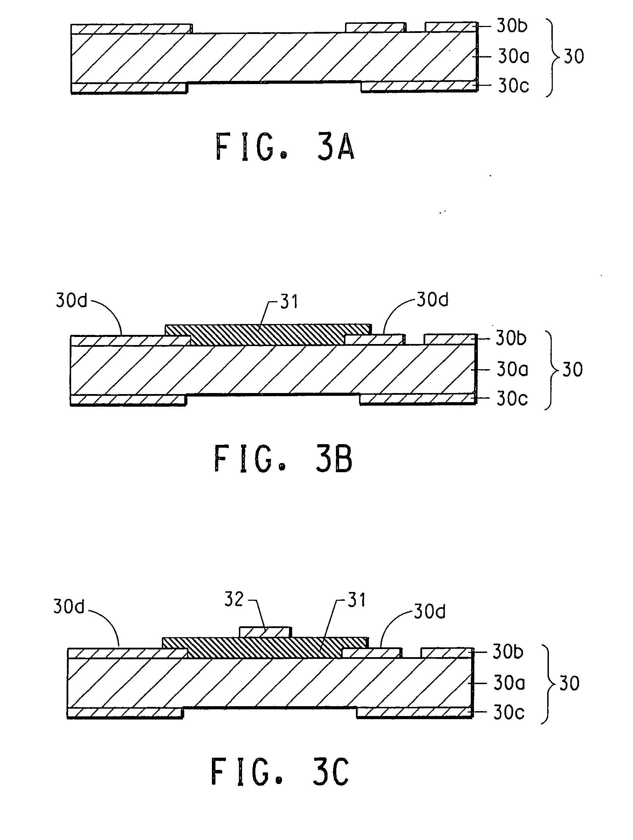

Figures 3(a)-(c) sequentially explain the manufacturing processes of a side up type circuit substrate. In (a)-(d) of the figures, 30 is a core part of an organic laminate composed of a prepreg 30a and an Cu foil 30b, 30d work as electrode, 31 is a resistor, and 32 is a trimming part.

When the side up type circuit substrate is formed, first, using the core part 30 of the organic laminate shown in Figure 3(a), as shown in Figure 3(b), the resistor 31 is printed and cured on said core part 30. As the printing method, for example, screen printing is used. During printing, the resistor 31 is connected to the Cu foil 30b. The connected part 30d is worked as electrode.

As shown in Figure 3(c), in order to control the resistance value of the resistor formed on the circuit substrate, a trimming resistor is formed. In the method for manufacturing the trimming resistor of the present invention, the trimming composition 32 is spread in the direction perpendicular to the paper on the resistor 31. At that time, as shown in Figure 1(d), the trimming composition is spread so that both ends 14 and 15 of the trimming part 13 (32) may protrude to the outside of both sides of the resistor. In this manner, the trimming resistor consisting of electrode 30d, resistor 31, and trimming part 32 is formed on the prepreg (substrate) 30a.

In the case when the trimming resistor is formed in the above-mentioned side down type (Figure 2) and side up type (Figure 3) circuits, the method for spreading the trimming compositions 24 and 32 explained in detail. The electrical conductivity of the trimming composition has a relation to the amount of resistance value being changed by trimming. If the resistance value of the trimming composition is low, the amount of resistance value being changed by trimming is increased. For a higher-precision trimming, a trimming composition with a high resistance value can also be used to reduce the amount being changed. High efficiency trimming is made possible by selecting a trimming composition suitable for the necessary amount of resistance value being changed. Since the trimming composition has been mentioned above, its explanation is omitted here. The method for spreading the trimming composition is not particularly limited. For example, a method using an ink-jet device or a method using a dispenser is mentioned. Where precise control is not required or when a prototype is manufactured, the trimming composition can also be spread by hand coating.

When an ink-jet device is used, the trimming composition is put into a liquid reservoir of the ink-jet printer head and spread in a dot shape. In such spreading, the average diameter of dots being spread is appropriately (for example, 10-30 µm) selected in accordance with the average diameter of the particles being spread, and the quantity of liquid drops is determined in accordance with the selection of the particle diameter. In other words, the ink-jet device jets fire liquid drops suitable for the average diameter of the dots. For this reason, the quantity of liquid drops depends on the performance of the ink-jet printer head itself being used. Therefore, it is preferable to select a printer head suitable for the intended amount of liquid drops.

In the present invention, even if the size of the trimming part protruding to the outside of the resistor is to a greater or lesser degree shifted from the expected size, it has no negative influence on the resistance value. For this reason, when the trimming composition is spread using an ink-jet device, the degree of freedom for the spreading control is raised. It is not necessary to control the ink-jet device with high precision, and the workability is improved.

In spreading the trimming composition, a trimming part with the desired shape may also be formed by continuously supplying [applying] the composition. For example, if the trimming composition is spread using an ink-jet system, the trimming composition is continuously applied to a desired position by moving the head, and a prescribed shape is drawn.

If the area where nozzles of the ink-jet system are arranged is wide, the trimming composition may also be simultaneously applied from several nozzles. For example, an ink-jet device in which the arrangement width of the nozzles is greater than the width between both sides of the resistor is prepared, and the trimming composition is applied so that the width may be greater than the width between both sides of the resistor. Then, the trimming composition is sequentially applied from the nozzles by moving the nozzles in the direction from one electrode toward the other electrode. With repetition of this pattern, a trimming part with a prescribed width can be formed.

Sometimes, an ink-jet device in which the arrangement size of the nozzles is greater than an expected trimming part size is prepared. Then, the nozzles are moved to the part for forming the trimming part, and the trimming composition is fired from the nozzle corresponding to the part forming the trimming part. If this process is adopted, the trimming composition can be very efficiently provided, so that the manufacturing efficiency of the trimming resistor is raised.

When a desired shape is formed by sequentially applying the trimming composition, it is preferable to spread the trimming composition so that the spreading start position and the spreading end position of the trimming composition may be located outside the resistor. When the trimming composition is spread, spreading irregularities are easily caused at the spreading start position and the spreading end position. For this reason, a negative influence of the spreading irregularities on the trimming precision is prevented by spreading the trimming composition so that the spreading start position and the spreading end position of the trimming composition may be located outside the resistor. As the method for spreading the trimming composition, spreading methods presented in JP 2005-019248, 2004-277627, and 2002-324966 can be appropriately used. However, as said spreading method, the use of spreading methods other than the above-mentioned methods is not excluded.

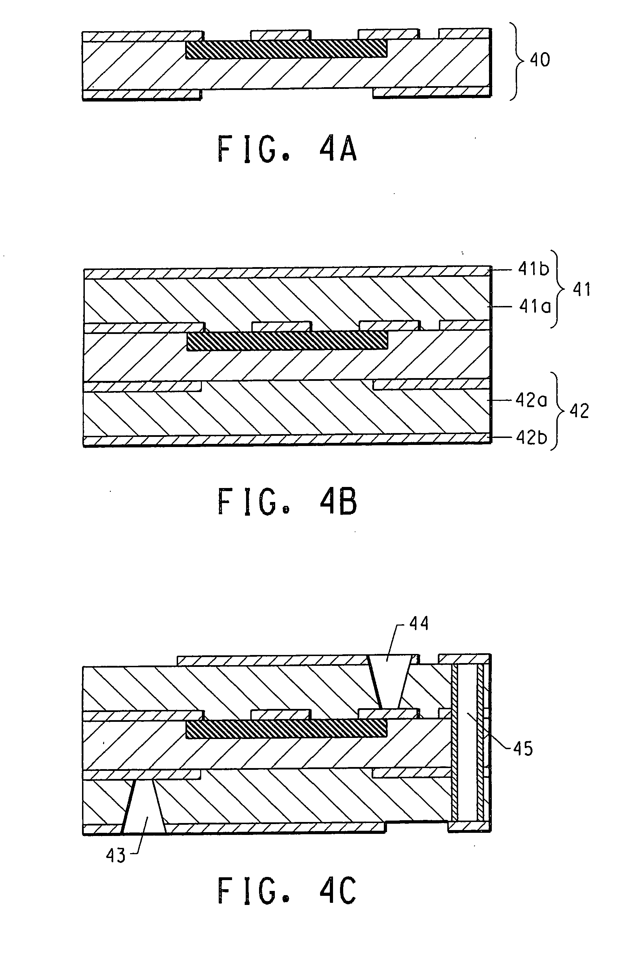

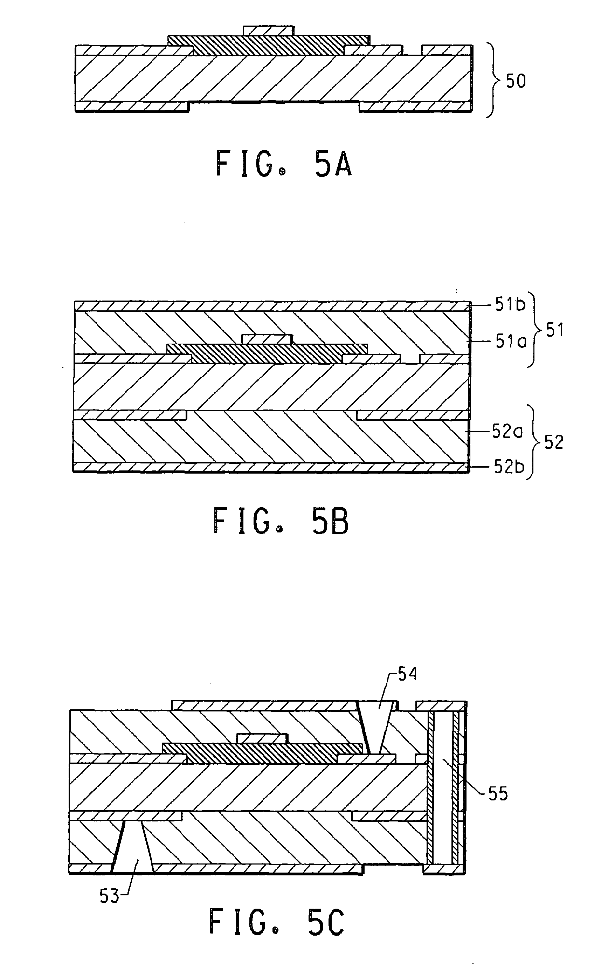

An example of the circuit substrate of the present invention is a laminated substrate. Detailed examples of the structure, for example, are shown in Figures 4(c) and 5(c), in which a core part of an organic laminate is joined with the upper and lower sides of a circuit including the trimming resistor obtained as mentioned above, and a inter layer connection is applied between each layer.

Figures 4(a)-(c) sequentially explain the manufacturing processes of a circuit substrate using the side down type circuit including the trimming resistor shown in Figure 2(e). In 4(a)-(c), 40 is a circuit equipped with the trimming resistor shown in Figure 2(e), 41 is an organic laminate consisting of a prepreg 41 a and an Cu foil 41 b, 42 is an organic laminate consisting of a prepreg 42a and an Cu foil 42b, and inter layer connection 43, 44, and 45.

In manufacturing the circuit substrate shown in Figure 4(c), first, a laminate with a four-layer structure is formed as shown in Figure 4(b) by laminating the layer 41 and 42 with the circuit 40 shown in Figure 4(a). Next, make inter layer connection 43-45, as shown in Figure 4(c). In this manner, four layer circuit board is formed. Furthermore, with repetition of the lamination, a circuit substrate with a multilayer structure is formed.

The circuit substrate shown in Figure 4(c) is equipped with the trimming resistor of the present invention. For this reason, a desired resistance value can be obtained, and excellent reliability can be realized.

Figures 5(a)-(c) sequentially explain the manufacturing processes of a circuit substrate using the side up type circuit shown in Figure 3(c). In (a)-(c) of the figure, 50 is a circuit equipped with the trimming resistor shown in Figure 3(c), 51 is a layer of an organic laminate consisting of a prepreg 51 a and an Cu foil 51 b, 52 is a layer of an organic laminate consisting of a prepreg 52a and an Cu foil 52b. Next, make inter layer connection 53, 54, and 55. Furthermore, with repetition of the lamination, a circuit substrate with a multilayer structure is formed.

As in the circuit substrate shown in Figure 4(c), the circuit substrate shown in Figure 5(c) is equipped with the trimming resistor of the present invention. For this reason, a desired resistance value can be obtained, and excellent reliability can be realized.

### EXAMPLES

The present invention is further explained by an application example; however, the following application example does not intend to limit the present invention to those examples.

### Example 1

An organic laminate (electrode: copper, resistor: EP204 made by Du Pont Co.) built with 21 resistor units with a size of 1.5 mm x 1.5 mm was prepared, and the resistance value of each resistor was measured by a digital multimeter. Also, as a trimming composition to be spread on the resistors, an electroconductive paste was prepared. As the electroconductive paste, a polymeric silver paste 5450 made by Du Pont Co. was used.

As shown in Figure 1(b), the electroconductive paste was spread at various widths so that the trimming part might protrude to the outside of both sides of the resistor corresponding to the current flow direction in the resistor. As for the width, the width in the horizontal direction of the paper was changed in Figure 1(b). The electroconductive paste was dried and cured at 150°C for 30 min, and the resistance value was re-measured. The relation equation between the change rate of the resistance value (the resistance value after spreading the paste/the resistance value before spreading the paste) and spreading width of the electroconductive paste was obtained by an approximation of the least square method. The correlation coefficient of the approximation equation was 0.81. The difference between the calculated resistance value obtained from the approximation equation of each resistor and the actual resistance value was calculated by %, and its standard deviation was 1.8%.

### Comparative Example 1

Similarly to Application Example 1, an organic laminate built with 21 resistor units and a DuPont 5450 electroconductive paste were prepared. As shown in Figure 2 of JP H05[1993]-13206, the electroconductive paste was spread at various widths so that one end of the trimming part might protrude to the outside of the resistors, with the other end at the upper part of the resistor. The electroconductive paste was cured and dried at 150°C for 30 min, and the resistance value was re-measured. The relation equation between the change rate of the resistance value (the resistance value after spreading the paste/the resistance value before spreading the paste) and spreading width of the electroconductive paste was obtained by an approximation of the least square method. The correlation coefficient of the approximation equation was 0.77. The difference between the calculated resistance value obtained from the approximation equation of each resistor and the actual resistance value was calculated by %, and its CV (standard deviation divided by average) was 6.0%.

The results of the above Application Example 1 and Comparative Example 1 are shown in Table I.

**Table I**

| | Number of resistors | Correlation coefficient of approximation equation | CV |
|---|---|---|---|
| Application Example 1 | 21 | 0.81 | 1.8% |
| Comparative Example 1 | 21 | 0.77 | 6.0% |

According to Table I, when the electroconductive paste is spread so that both ends of the trimming part may protrude to the outside of the resistor, the CV is small. In other words, it is understood that scattering of the resistance value is small.

On the contrary, when the electroconductive paste is spread so that one end of the electroconductive paste may remain, the CV is large. In other words, it is understood that scattering of the resistance value is large.

From the comparison between Application Example 1 and Comparative Example 1, it is understood that the present invention is effective for high-precision trimming.

## Claims

1. A trimming resistor, comprising:
a resistor body disposed on a circuit substrate; and
a trimming part disposed on the resistor body, the trimming part protruding from the both ends of the resistor body and across the direction of the electric current in the resistor body.

2. A trimming resistor according to claim 1, the conductivity of the trimming part being same as the conductivity of the resistor.

3. A trimming resistor according to claim 1, the conductivity of the trimming part being different from the conductivity of the resistor.

4. A trimming resistor according to claim 3, the conductivity of the trimming part being lower than the conductivity of the resistor body.

5. A trimming resistor according to claim 3, the conductivity of the trimming part being higher than the conductivity of the resistor body.

6. A trimming resistor according to claim 1, the shape of the trimming part is rectangle.

7. A method for production of trimming resistor, comprising steps of:
preparing a resistor body disposed on a circuit substrate; and
applying a trimming composition so that a trimming part, which is formed by curing the trimming composition, can protrude from both ends of the resistor body and across the direction of the electric current in the resistor body.

8. A method for production of trimming resistor according to claim 6, the conductivity of the trimming part being same as the conductivity of the resistor.

9. A method for production of trimming resistor, according to claim 6, the conductivity of the trimming part being different from the conductivity of the resistor.

10. A method for production of trimming resistor according to claim 8, the conductivity of the trimming part being lower than the conductivity of the resistor body.

11. A method for production of trimming resistor according to claim 8, the conductivity of the trimming part being higher than the conductivity of the resistor body.

12. A method for production of trimming resistor according to claim 6, the trimming composition being applied by use of dispenser or ink-jet devise.

13. A method for production of trimming resistor according to claim 6, the trimming composition being applied by use of ink-jet devise.

14. A method for production of trimming resistor according to claim 6, the trimming composition being applied in a direction parallel to the flow of current in such a way that the width of the coating is longer than the width of the resistor body.

15. A method for production of trimming resistor according to claim 11, wherein the step of applying a trimming composition comprises steps of:
preparing an ink-jet devise, the area where nozzles are disposed being larger than the area of the trimming part;
moving the nozzles to a place where the trimming part is formed; and
ejecting the trimming composition from the nozzle corresponding to the place where the trimming part is formed.

16. A method for production of trimming resistor according to claim 6, a starting point of the application of the trimming composition and a finishing point of the application of the trimming composition existing out of the both sides.

17. A circuit board, comprising a trimming resistor of claim 1.

18. A circuit board according to claim 15, the circuit substrate being an organic laminated board comprising a polymer.
